Europäisches Patentamt

European Patent Office

Office européen des brevets

(11) Publication number: **0 182 631**
**A2**

# EUROPEAN PATENT APPLICATION

(21) Application number: 85308346.7

(22) Date of filing: **15.11.85**

(51) Int. Cl.⁴: **H01L 27/14**

(30) Priority: **20.11.84 JP 245601/84**

(43) Date of publication of application:
**28.05.86 Bulletin 86/22**

(84) Designated Contracting States:
**DE GB**

(71) Applicant: **SEIKO INSTRUMENTS & ELECTRONICS LTD.**
**31-1, Kameido 6-chome**
**Koto-ku Tokyo 136(JP)**

(72) Inventor: **Iwanami, Eiichi**
**c/o Seiko Instruments & Elect. Ltd 6-31-1, Kameido**
**Koto-ku Tokyo(JP)**
Inventor: **Kawahara, Yukito**
**c/o Seiko Instruments & Elect. Ltd 6-31-1, Kameido**
**Koto-ku Tokyo(JP)**
Inventor: **Mukainakano, Hiroshi**
**c/o Seiko Instruments & Elect. Ltd 6-31-1, Kameido**
**Koto-ku Tokyo(JP)**

(74) Representative: **Caro, William Egerton et al**
**J. MILLER & CO. Lincoln House 296-302 High Holborn**
**London WC1V 7JH(GB)**

(54) Semiconductor reading device.

(57) A semiconductor reading device comprises bipolar transistors which operate as phototransistors ($P_1...P_n$), a drive circuit including an MOS switching transistor ($S_1...S_n$) connected to each phototransistor, the switching transistors being arranged successively to switch the phototransistors, and shift registers ($SR_1...SR_n$) composed of MOS transistors connected to drive the switching transistors. The phototransistors and drive circuits are equi-spaced apart in rows along a semiconductor substrate (1).

EP 0 182 631 A2

## "SEMICONDUCTOR READING DEVICE"

This invention relates to semiconductor reading devices which, for example, convert reflected light from a manuscript into electric signals.

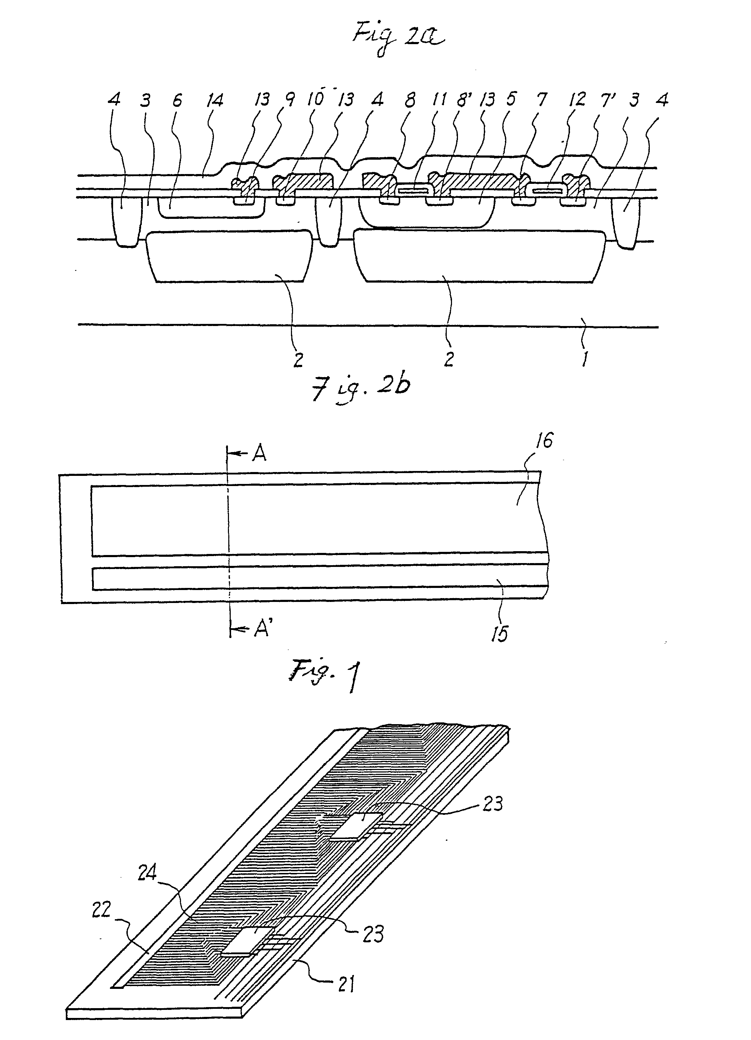

Figure 1 is a diagram of a conventional contact semiconductor reading device. This conventional contact reading device has a photocell array 22 of, for example, amorphous silicon formed on an insulating substrate 21 of glass or alumina. A plurality of integrated circuits 23 function either successively to read electric outputs of the photocell array or to amplify the electric outputs. Wiring 24 connects the photocell array 22 to the integrated circuits 23.

When this conventional contact reading device is designed to read an A4 manuscript, a resolution corresponding to 8 dots is necessary to read a 1 mm portion of the manuscript. Thus approximately 2000 photocells spaced apart by 125 μm in the longitudinal direction are necessary. The wiring to pick up the signals from such a number of photocells becomes very extensive, and more than ten integrated circuits 23 for signal processing are required. The result is that connecting the wiring and the integrated circuits is difficult, and manufacturing yield is reduced. Furthermore, the wiring 24 has to be formed so that the integrated circuits 23 can be mounted on the insulating substrate 21, with the result that the area of the insulating substrate occupied by the wiring will be several tens of times the total area occupied by the photocell array 22. Thus it is not possible to manufacture the conventional contact reading device at low cost. As the wiring connecting the photocells and the integrated circuits must be different in length, their wiring capacitance and wiring resistance differ so effecting the electric signals obtained. The integrated circuits necessary to counter-act this effect are complicated but without such specifically designed integrated circuits the contact reading device will not be highly accurate.

The present invention seeks to provide a semiconductor reading device which overcomes the problems associated with the conventional contact reading device of Figure 1.

According to the present invention there is provided a semiconductor reading device characterised by comprising: a plurality of bipolar transistors which operate as phototransistors; a drive circuit including a MOS switching transistor connected to each phototransistor, the switching transistors being arranged successively to switch the phototransistors; and a plurality of shift registers composed of MOS transistors connected to drive the switching transistors, the phototransistors and drive circuits being equi-spaced apart in rows along a semiconductor substrate.

Each phototransistor may have the same measurements in the longitudinal and lateral directions.

In one embodiment the pitch of the phototransistors arranged on the semiconductor substrate is 125 μm, each phototransistor being between 10 μm and 95 μm in the lateral direction and between 50 μm and 125 μm in the longitudinal direction.

In another embodiment the pitch of the phototransistors on the semiconductor substrate is 62.5 μm, each phototransistor being between 10 μm and 32.5 μm in the lateral direction and between 25 μm abd 62.5 μm in the longitudinal direction.

The invention is illustrated, merely by way of example, in the accompaning drawings, in which:-

Figure 1 is a perspective view of a conventional contact semiconductor reading device;

Figure 2a is a sectional diagram of part of an embodiment of a semiconductor reading device according to the present invention, taken along line A-A' of Figure 2b,

Figure 2b is a plan view of the semiconductor reading device of Figure 2a; and

Figure 3 is an equivalent circuit diagram of the semiconductor reading device of Figure 2a.

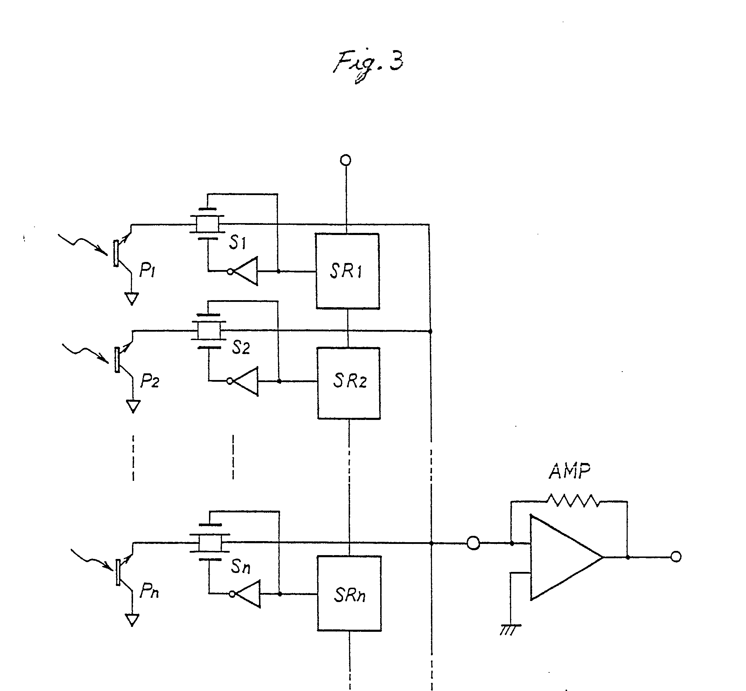

Figure 2a is a section through part of an embodiment of a semiconductor reading device according to the present invention. The semiconductor reading device has a P-type conductive elongate substrate 1 and an N type built-in layer 2 of high impurity density where, to keep the surface impurity density to $5 \times 10^{18}$ atoms/cm³, antimony etc. is diffused therein. An N type epitaxial layer 3 has an impurity density of $5 \times 10^{14}$ to $6 \times 10^{14}$ atoms/cm³, and a thickness of approximately 5 to 15 μm. A P-type separation layer 4 is formed to reach the substrate 1 through the surface of the epitaxial layer 3, this separation layer 4 being formed to surround each phototransistor described hereinafter. It is desirable to set the width of the separation layer 4 in the longitudinal direction to be more than 40 μm when the resolution for reading a manuscript is 8 dots/mm (8 dots being necessary to read 1mm along the manuscript) and it is desirable to set the width of the separation layer to be more than 20 μm for a resolution of 16 dots/mm. A P-type well 5 of an N-channel MOS transistor has a surface impurity density of $1 \times 10^{16}$ atoms/cm³, and a depth of 3 to 8 μm. A base 6 of the phototransistor has a surface impurity of $1 \times 10^{16}$ to $1 \times 10^{18}$ atoms/cm³ and a depth of 1.5 to 5 μm. The base 6 can be formed simultaneously with the P-type well 5. Reference numerals 7, 7' indicate a P-type drain and a P-type source respectively of a P-channel MOS transistor, their impurity density being high. Reference numerals 8, 8' show a N-type source and a N-type drain of the N-channel MOS transistor being formed in the P-type well 5 with high impurity density. The surface impurity density of the source and drain of the MOS transistor is more than $1 \times 10^{19}$ atoms/cm³, and the source and drain have a depth of 0.1 to 3.0 μm. An emitter 9 of the phototransistor has a surface impurity density of $1 \times 10^{19}$ atoms/cm³ and a depth of 0.1 to 3.0 μm. A collector 10 of the phototransistor is formed on the surface of the epitaxial layer 3 with the same density profile. Reference numerals 11, 12 indicate gates of the N-channel and P-channel MOS transistors, respectively, formed by phosphorous-doped or boron-doped polycrystalline silicon. Metallic wiring 13 composed of aluminium etc interconnects the above regions. As the wiring 13 usually reflects or absorbs light, it is desirable that it does not cover the base 6 of the phototransistor entirely. Therefore, the covered area of the base 6 should be less than half of the whole area. A passivation film 14 made for example, of silicon dioxide ($SiO_2$), silicon nitride ($Si_3N_4$) etc is provided with a thickness of about 1 to 2 μm. Furthermore, the scattering of the phototransistor outputs should be made small when outputting an 8 or 16 value signal compared to when outputting a 2 value signal. Thus the formation of the plurality of phototransistors is as follows.

When the resolution for reading 8 dot/mm is required, the pitch in the longitudinal direction of adjacent phototransistors is 125 μm, but in practice may be 95 μm as a maximum considering the mutual interference between phototransistors and cutting or patterning accuracy. The pitch in the lateral direction is 10 µm as a minimum, because of lithography technology and the limitation of the output of the phototransistors. The measurement in the longitudinal direction will be 125 µm at a maximum from the limitation of pitch, and as a minimum of 50 µm because of limitation of phototransistors. On the other hand for a resolution for reading 16 dots/mm, the pitch in the longitudinal direction will be 62.5 µm. Similarly to the case of 8 dots/mm, the pitch in the lateral direction should be 10 µm to 32.5 µm, and in the longitudinal direction 25 to 62.5 µm. The region of the phototransistor that senses light will be that region where light is not blocked by metallic wiring.

The above described semiconductor reading device is formed by conventional semiconductor circuit manufacturing techniques such as ion implantation, thermal diffusion, photo-lithography, vapour phase epitaxial growth, chemical vapour deposition, vacuum evaporation, or sputtering. Phototransistors and/or MOS transistors of the opposite conductivity type to that shown can, of course, be utilized. Also the MOS transistors may solely be N channel transistors. The gates of the MOS transistors can be formed of metal such as aluminium. Moreover, on the surface of the single crystal below the gate, phosphorous or phorone (boron) may be ion-implanted to control the threshold voltage.

Figure 2b is a partial plan view of the semiconductor reading device of Figure 2a. A plurality of phototransistors each consisting of the base 6, the emitter 9, and the collector 10 are disposed in a straight row 15. A drive circuit is provided for each phototransistor, the circuits being arranged in a straight row 16. As will be appreciated the phototransistors and drive circuits are in pairs, and the width of each pair in the lateral direction is approximately the same.

Figure 3 is an equivalent circuit diagram of the semiconductor reading device of Figure 2a. A plurality of phototransistors $P_1$, $P_2$...$P_n$ have their collectors connected to a high potential, their bases in a floating state and their emitters are connected to the drive circuit side of a respective one of a plurlaity of MOS transistor switches $S_1$, $S_2$...$S_n$. Shift registers $SR_1$, $SR_2$...$SR_n$ are connected to the switches $S_1$, $S_2$...$S_n$ respectively. An amplifier AMP amplifies current-voltage at the output terminals of the switches $S_1$, $S_2$...$S_n$. The amplifier AMP is not essential and when not utilized, the offset voltage is especially small, and bipolar transistors with high gain and very efficient frequency characteristics can be utilized.

The operation of the semiconductor reading device will now be described. Light reflected from a manuscript falls on the phototransistors $P_1$, $P_2$...$P_n$ and if the part of the manuscript corresponding to the phototransistor $P_1$, for example, is white, very strong light incidence will occur. Therefore holes and electrons are generated in the phototransistor $P_1$. Due to the potential generated at a PN junction formed by the base and the active collector in the epitaxial layer, the holes and electrons migrate to the base and the epitaxial layer respectively. This operation takes place during a time which determines the time needed to read one line of the manuscript. Next, when the switch $S_1$ is turned ON by the output of the shift register $SR_1$, the phototransistor $P_1$ changes to the bias condition from the floating condition, and so the emitter of the phototransistor is connected to the input terminal of the amplifier AMP. Therefore, due to the accumulation of holes, the base of the phototransistor is biassed forward and, due to the potential applied to the collector, a relatively large electric current passes from the collector to the emitter, through the switch from the emitter to the input terminal of the amplifier AMP. Thus a relatively large voltage is generated at the output terminal of the amplifier AMP.

On the other hand, if the manuscript portion corresponding to the phototransistor $P_1$ is black, the irradiated light falling on this phototransistor will be weak, and almost no holes of electrons will accumulate on the base and the epitaxial layer respectively of the phototransistor $P_1$. Therefore even when the switch $S_1$ is turned ON, almost no electric current passes, and the voltage generated at the output terminal of the amplifier AMP will be relatively small.

If the colour of the manuscript portion corresponding to the phototransistor $P_1$ is grey, a correspsonding current from the phototransistor passes through the switch $S_1$ when it is turned on, and the output voltage of the amplifier AMP will be intermediate the voltages when the document portion is white and black. The operation is successively repeated for each of the phototransistors $P_1$, $P_2$...$P_n$ arranged in a longitudinal direction. The output current obtained from the phototransistors $P_1$, $P_2$...$P_n$ is approximately two orders of magnitude larger than the electric current generated by photo cells such as amorphous silicon photo diodes or PN photo diodes of the same size. Thus by utilizing photo transistors $P_1$, $P_2$...$P_n$, the effect of noise generation at the switches $S_1$, $S_2$...$S_n$ will be relatively small. Also as the enlargement of the capacitance generated by connecting wiring from a plurality of phototransistors to the amplifier AMP will decrease, the sensitivity of the whole semiconductor reading device will not be substantially reduced.

The present invention utilizes phototransistors and so the sensitivity is more than an order of magnitude larger compared to the conventional diode type semiconductor reading device. Therefore the area of the phototransistors may be reduced and, as a result, there is the possibility of reducing the size of the chip, and an oblong-shaped semiconductor reading device can easily be obtained at a relatively low cost, by directly connecting a plurality of chips in the lateral direction. Also by forming the phototransistors and drive circuits on a single crystal substrate in monolithic style, the wiring which connects the phototransistors and the respective drive circuits may be made relatively short and uniform. Therefore, sensitivity is increased and differences between output of the phototransistors reduces. With the conventional semiconductor reading device, there is a problem with the integrated circuits with measurement at 16 dots/mm because individual drive circuits are connected with, for example, wire bonds, or connection is extremely difficult because of colorization, but these problems are simultaneously solved with the above semiconductor reading device according to the present invention.

As explained so far, with the present invention, it is possible to obtain a relatively low priced and small size contact semiconductor reading device for reading manuscripts, and so multi-function ability and high efficiency can be achieved in facsimile machines, multi-purpose scanners, word processors etc. Therefore, the present invention can contribute significantly to the development of electronic instruments.

Furthermore, with semiconductor reading devices according to the present invention as the phototransistors and drive circuits are formed on the same single crystal substrate, the wiring to connect the two can be easily effected simultaneously with the wiring of the drive circuits, the length of the wiring will be reduced and it is possible to remove shape differences. Also as the luminosity of the phototransistors is one order of magnitude larger than conventional, not only is the construction of the amplifier made simpler but also high speed operation is possible.

## Claims

1. A semiconductor reading device characterised by comprising: a plurality of bipolar transistors which operate as phototransistors ($P_1...P_n$); a drive circuit including a MOS switching transistor ($S_1...S_n$) connected to each phototransistor, the switching transistors being arranged successively to switch the phototransistors; and a plurality of shift registers ($SR_1...SR_n$) composed of MOS transistors connected to drive the switching transistors ($S_1...S_n$), the phototransistors and drive circuits being equi-spaced apart in rows along a semiconductor substrate (1).

2. A semiconductor reading device as claimed in claim 1 characterised in that each phototransistor ($P_1...P_n$) has the same measurements in the longitudinal and lateral directions.

3. A semiconductor reading device as claimed in claim 1 or 2 characterised in that the pitch of the phototransistors ($P_1...P_n$) arranged on the semiconductor substrate is 125 μm, each phototransistor being between 10 μm and 95 μm in the lateral direction and between 50 μm and 125 μm in the longitudinal direction.

4. A semiconductor reading device as claimed in claim 1 or 2 characterised in that the pitch of the phototransistors ($P_1...P_n$) on the semiconductor substrate is 62.5 μm, each phototransistor being between 10 μm and 32.5 μm in the lateral direction and between 25 μm and 62.5 μm in the longitudinal direction.

5. A semiconductor device comprising bipolar transistors which operate as phototransistors, and drive circuits composed of switching MOS transistors which successively switch said phototransistors, and of shift registers composed of MOS transistors which drive said switching MOS transistor, wherein light reading circuit is composed of said phototransistor and said drive circuit, and a plurality of phototransistors and a plurality of said drive circuits are respectively arranged in a straight line with equal space on a semiconductor substrate.

*Fig 2a*

*Fig. 2b*

*Fig. 1*

## Fig. 3